(19) Europäisches Patentamt
European Patent Office
Office européen des brevets

(11) Veröffentlichungsnummer: **0 022 483**
**B1**

(12) **EUROPÄISCHE PATENTSCHRIFT**

(45) Veröffentlichungstag der Patentschrift:
23.03.83

(51) Int. Cl.³: **H 01 L 29/76, H 01 L 29/06**

(21) Anmeldenummer: **80103476.0**

(22) Anmeldetag: **21.06.80**

(54) Feldeffekt-Transistor und Verfahren zu seiner Herstellung.

(30) Priorität: 03.07.79 DE 2926741

(43) Veröffentlichungstag der Anmeldung:
21.01.81 Patentblatt 81/3

(45) Bekanntmachung des Hinweises auf die Patenterteilung:
23.03.83 Patentblatt 83/12

(84) Benannte Vertragsstaaten:
FR GB IT NL

(56) Entgegenhaltungen:
DE-A-1 489 667
DE-A-1 514 727
DE-A-2 837 394
GB-A-1 107 248
SOLID-STATE ELECTRONICS, Band 11, 1968
Oxford S. SCHÄFER »Herstellung von p-n-
Übergängen durch gemeinsame plastische Verformung von p- und n-dotiertem Germanium«

(73) Patentinhaber: Licentia Patent-Verwaltungs-GmbH,
Theodor-Stern-Kai 1, D-6000 Frankfurt/Main 70 (DE)

(72) Erfinder: Dahlberg, Reinhard, Dr., Innere Bergstrasse 32,
D-7101 Flein (DE)

(74) Vertreter: Maute, Hans-Jürgen, Dipl.-Ing., Licentia
Patent-Verwaltungs-GmbH Theodor-Stern-Kai 1,
D-6000 Frankfurt/Main 70 (DE)

## Feldeffekt-Transistor und Verfahren zu seiner Herstellung

Die Erfindung beschreibt einen Feldeffekt-Transistor mit p/n-, MOS- oder Schottky-Feldeffekt-Kontakten.

Wegen der Hochohmigkeit der Eingangsimpedanzen wird der Feldeffekt-Transistor bei speziellen Anwendungen in der Praxis häufig dem Bipolar-Transistor vorgezogen. Es gibt heute eine Reihe von Verfahren, nach denen Feldeffekt-Transistoren hergestellt werden. Die in letzter Zeit entwickelte sogenannte V-MOS-Technologie gestattet die Realisierung von Feldeffekt-Transistoren mit besonders großen Leistungen. Ein Nachteil auch dieser Feldeffekt-Transistoren liegt in den relativ hohen Herstellkosten.

Die Erfindung beschreibt einen Feldeffekt-Transistor mit versenktem Gate, der bei großen Leistungen Herstellungsvorteile besitzt.

Feldeffekttransistoren mit versenktem Gate sind beispielsweise aus GB-A-1 107 248 bekannt.

Der Feldeffekt-Transistor der Erfindung ist dadurch gekennzeichnet, daß zwei Halbleiterscheiben gleichen Leitfähigkeitstyps vorgesehen sind, daß auf einer Seite jeder Scheibe eine Struktur aus parallel zueinander verlaufenden Wällen vorgesehen ist, daß die beiden Scheiben mit ihren strukturierten Seiten unter mechanischem Druck so zusammengesetzt sind, daß die Wälle beider Scheiben sich kreuzen und berühren, so daß eine flächenhafte Verteilung von elektrisch parallel geschalteten Engewiderständen zwischen den beiden Halbleiterscheiben vorhanden ist, und daß für jeden Engewiderstand eine Gate-Elektrode vorgesehen ist.

Das Prinzip der gekreuzten, parallelen Wälle wird bereits in der deutschen Offenlegungsschrift DE-A-2 547 262 beschrieben. Die Ausgestaltung dieses Prinzips als Feldeffekt-Transistor wird jedoch in der DE-A-2 547 262 nicht erwähnt.

Bei dem erfindungsgemäßen Feldeffekt-Transistor kann als Gate-Elektrode ein Halbleitermaterial vorgesehen werden, das mit den Engewiderständen einen p/n-Übergang bildet. Ferner kann aber auch ein MOS-Kontakt oder ein Schottky-Kontakt die Gate-Elektrode bilden. Der Schottky-Kontakt kann erfindungsgemäß auch dadurch an den Engewiderständen gebildet werden, daß sich zwischen den Strukturen beider Scheiben eine dünne Metallfolie oder eine metallisierte Isolatorfolie befindet. Auch der elektrische Anschluß einer Gate-Elektrode aus Halbleitermaterial oder in Form eines MOS-Kontaktes kann durch eine Metallfolie oder eine metallisierte Isolatorfolie erfolgen, welche zwischen die Strukturen beider Scheiben gelegt ist. Beim Zusammensetzen der beiden Scheiben unter mechanischem Druck wird die Metallfolie oder die metallisierte Folie von den Berührungsstellen weggedrückt.

Die beiden Halbleiterscheiben können einkristalline Struktur haben und bei so hoher Temperatur zusammengesetzt werden, daß die parallelen Engewiderstände zwischen den beiden Halbleiterscheiben als Folge von plastischer Verformung des Halbleitergitters in einkristalline Engewiderstände umgewandelt werden.

Als Material für die Halbleiterscheiben können einkristalline oder polykristalline Elementhalbleiter oder Verbindungshalbleiter verwendet werden.

Der Feldeffekt-Transistor der Erfindung kann als Schalter und als Leistungs-Verstärker verwendet werden.

Im folgenden wird die Erfindung anhand von 3 Ausführungsbeispielen näher beschrieben.

Ausführungsbeispiel 1 zeigt einen MOS-p-Silizium-Feldeffekt-Transistor.

Ausführungsbeispiel 2 beschreibt einen n-Silizium-Feldeffekt-Transistor mit p/n-Gate-Kontakten.

Ausführungsbeispiel 3 beschreibt einen n-GaAs-Feldeffekt-Transistor mit Schottky-Gate-Kontakten.

### Ausführungsbeispiel 1

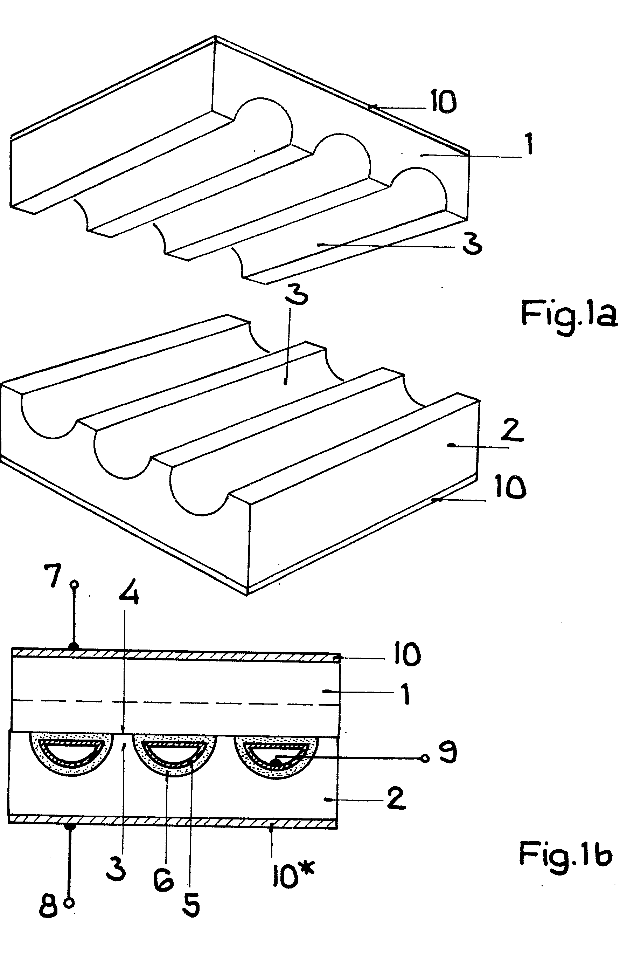

In Fig. 1 sind 1 und 2 p-Siliziumscheiben mit einem spezifischen elektrischen Widerstand von 100 $\Omega$cm. Eine Seite jeder Scheibe 1 und 2 trägt eine Struktur mit zueinander parallel verlaufenden Wällen 3, die sich zur freiliegenden Stirnfläche hin bis auf eine Restbreite von $10^{-3}$ cm verjüngen. Die Scheibe 1 wird bezüglich der Wallstrukturen um 90° gegen die Scheibe 2 in der Scheibenebene verdreht unter definiertem Druck auf die Scheibe 2 gelegt, so daß die Wälle 3 beider Scheiben 1 und 2 sich kreuzen und sechzehn Berührungsstellen 4 bilden (wie in Fig. 1b dargestellt). Durch Erhitzen auf 900°C werden die Berührungsstellen 4 in sechzehn einkristalline Engewiderstände 4 mit je einer Fläche von $1 \cdot 10^{-6}$ cm$^2$ und einem elektrischen Widerstand von $\sim 10^5$ Ohm umgewandelt. Die freiliegenden Oberflächenteile der Wälle 3 werden danach mit einer thermischen Quarzschicht oder Glasschicht 6 überzogen. Die Quarzschicht 6 wird über eine elektrodenlose Abscheidung mit der Doppelschicht Kupfer/Gold 5 mit einer Gesamt-Dicke von $3 \cdot 10^{-5}$ cm überzogen. 10 und 10* sind sperrfreie Kontakte an den Scheiben 1 und 2 auf den den Wallstrukturen gegenüberliegenden Oberflächenseiten. An diese Kontakte sind die Drain-Elektrode 7 und die Source-Elektrode 8 angeschlossen. Die Gate-Elektrode 9 ist mit der Kupfer/Gold-Schicht 5 elektrisch verbunden. Der Feldeffekt-Transistor hat für die Gate-Spannung null einen elektrischen Widerstand von ca. $7 \cdot 10^3$ Ohm. Bei einer Gate-Spannung von etwa 5 Volt steigt der Widerstand auf etwa $10^8$ Ohm.

## Ausführungsbeispiel 2

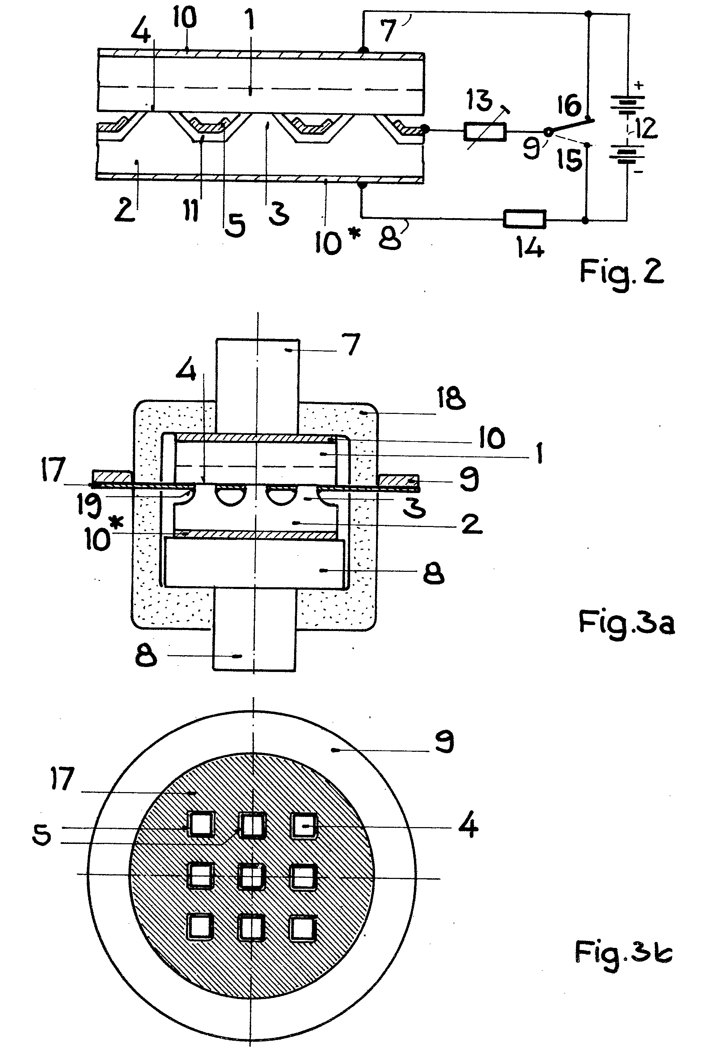

In Fig. 2 sind 1 und 2 n-Siliziumscheiben mit einer Kristallorientierung 100 und einem spezifischen Widerstand von 5 Ωcm. Beide Scheiben 1 und 2 haben auf einer Seite eine Struktur mit parallel zueinander verlaufenden Wällen 3, die sich stirnseitig auf eine Breite von $2{,}5 \cdot 10^{-4}$ cm verjüngen. Die Wälle wurden mit Hilfe eines Ätzprozesses erzeugt, bei welchem der Wall an seiner Stirnfläche durch eine Quarzschicht geschützt war. Diese Quarzschicht wurde anschließend bei der Eindiffusion der $p^+$-Schicht 11 als Maske benutzt. Sie wurde danach außerdem noch als Maske für das Aufdampfen der Wolfram-Schicht 5 verwendet. Nach Entfernen der (Wolfram-bedampften) Quarzschicht wurden die beiden Scheiben 1 und 2 bezüglich der Wallstrukturen um 90° gegeneinander verdreht unter Druck bei 850°C in Wasserstoff-Atmosphäre mit ihren strukturierten Oberflächenseiten zusammengefügt. Dabei wurden die Berührungsstellen 4 der sich kreuzenden Wälle in einkristalline Engewiderstände 4 umgewandelt. Die Gleichspannungsquelle 12, mit zum Beispiel 5 Volt, liegt über den elektrischen Widerstand 14 zwischen der Source-Elektrode 10 an der Scheibe 2 und der Drain-Elektrode 10* an der Scheibe 1. Die Gate-Elektrode 9 ist über den variierbaren Widerstand 13 elektrisch mit der Wolframschicht 5 an der $p^+$-Schicht 11 verbunden. Bei der Schalterstellung 15, bei der die Gate-Elektrode 9 mit negativem Potential verbunden ist, liegt an den Wolframschichten 5 und damit an den $p^+$-Schichten 11 eine negative Spannung von etwa 5 Volt, durch welche die Engewiderstände 4 als Folge der Raumladungszonen der p/n-Übergänge 11/2 sehr hochohmig gemacht werden. In der Schalterstellung 16, bei der die Gate-Elektrode 9 mit positivem Potential verbunden ist, liegt dagegen eine positive Spannung an den $p^+$-Schichten 11 und die p/n-Übergänge 11/2, sowie 11/1 sind in Flußrichtung gepolt. Dieser niederohmige Zustand der Engewiderstände stellt sich auch dann ein, wenn die Gate-Elektrode 9 und damit die $p^+$-Schichten 11 auf fließendem Potential liegen.

## Ausführungsbeispiel 3

In Fig. 3 sind 1 und 2 n-GaAs-Scheiben mit einem spezifischen el. Widerstand von 0,1 Ωcm. Beide Scheiben haben auf einer Seite eine Struktur aus parallel verlaufenden sich auf eine Breite von $2 \cdot 10^{-4}$ cm verjüngenden Wällen 3. Beide Scheiben 1 und 2 haben auf ihrer unstrukturierten Seite sperrfreie Kontakte 10 bzw. 10*. Die Scheiben 1 und 2 werden bezüglich der Strukturen gegeneinander in der Scheibenebene verdreht unter definiertem Druck und unter Zwischenlage der Platinfolie 17 mit einer Dicke von $2 \cdot 10^{-4}$ cm aufeinandergelegt. Die Platinfolie 17 wird an den Berührungsstellen 4 der sich kreuzenden Wälle 3 beider Scheiben 1 und 2 durchstoßen und so beiseite gedrückt, daß die quadratischen Berührungsstellen 4 von kleinen Wülsten 19 aus Platin umgeben sind, welche einen Schottky-Kontakt mit dem n-GaAs bilden. Der Feldeffekt-Transistor ist in das koaxiale Keramik-Gehäuse 18 eingeschlossen, bei welchem 7 die Source-Elektrode, 8 die Drain-Elektrode und 9 die Gate-Elektrode (mit dem elektrischen Kontakt zur Platinfolie 17) bedeuten.

In Fig. 3b ist schematisch in einer Darstellung der Berührungsebene beider Scheiben 1 und 2 angedeutet, wie die neun n-GaAs-Kontakte 4 von der Platinfolie 17 umschlossen werden und die Berührungsflächen 4 umschließende Schottky-Feldeffekt-Kontakte 5 mit dem n-GaAs bilden. Der Feldeffekt-Transistor hat im leitenden Zustand einen Widerstand von ca. 100 Ohm. Er ist bei einer Gate-Spannung größer als 15 Volt gesperrt.

### Bezugsziffern

| | |
|---|---|
| 1 | Halbleiterscheibe 1 |
| 2 | Halbleiterscheibe 2 |
| 3 | Wall |
| 4 | Engewiderstand |
| 5 | Gate-Elektrode |
| 6 | Quarzschicht oder Glasschicht |
| 7 | Drain-Elektrode |
| 8 | Source-Elektrode |
| 9 | Gate-Anschluß |
| 10, 10* | sperrfreier Kontakt |
| 11 | $p^+$-Schicht |
| 12 | Spannungsquelle |
| 13 | Gate-Vorwiderstand |
| 14 | Last-Widerstand |
| 15 | Schalter — Aus |
| 16 | Schalter — Ein |
| 17 | Platin-Folie |
| 18 | Keramik-Gehäuse |
| 19 | Platin-Wulst |

**Patentansprüche**

1. Feldeffekt-Transistor mit versenktem Gate, dadurch gekennzeichnet, daß zwei Halbleiterscheiben (1 und 2) gleichen Leitfähigkeitstyps vorgesehen sind, daß auf einer Seite jeder Scheibe eine Struktur aus parallel zueinander verlaufenden Wällen (3) vorhanden ist, daß die beiden Scheiben (1, 2) mit ihren strukturierten Seiten unter mechanischem Druck so zusammengesetzt sind, daß die Wälle (3) beider Scheiben (1, 2) sich kreuzen und berühren, so daß eine flächenhafte Verteilung von elektrisch parallel geschalteten Engewiderständen (4) zwischen den beiden Halbleiterscheiben (1, 2) vorhanden ist, und daß für jeden Engewiderstand (4) eine Gate-Elektrode (5) vorgesehen ist.

2. Feldeffekt-Transistor nach Anspruch 1, dadurch gekennzeichnet, daß als Gate-Elektrode (5) Halbleitermaterial vorgesehen ist, das mit den Engewiderständen (4) einen p/n-Übergang bildet.

3. Feldeffekt-Transistor nach einem der vorhergehenden Ansprüche, dadurch gekennzeichnet, daß als Gate-Elektrode (5) ein MOS-Kontakt vorgesehen ist.

4. Feldeffekt-Transistor nach einem der vorhergehenden Ansprüche, dadurch gekennzeichnet, daß als Gate-Elektrode (5) ein Schottky-Kontakt vorgesehen ist.

5. Feldeffekt-Transistor nach Anspruch 4, dadurch gekennzeichnet, daß zur Herstellung der Schottky-Kontakte (5) zwischen den strukturierten Oberflächenseiten beider Scheiben (1, 2) eine Metallfolie (17) oder eine metallisierte Isolatorfolie angeordnet ist.

6. Feldeffekt-Transistor nach einem der vorhergehenden Ansprüche, dadurch gekennzeichnet, daß als Halbleiter einkristalline oder polykristalline Element-Halbleiter oder Verbindungshalbleiter vorgesehen sind.

7. Feldeffekt-Transistor nach einem der vorhergehenden Ansprüche, gekennzeichnet durch seine Verwendung als Schalter.

8. Feldeffekt-Transistor nach einem der vorhergehenden Ansprüche, gekennzeichnet durch seine Verwendung als Leistungs-Verstärker.

9. Verfahren zum Herstellen eines Feldeffekt-Transistors nach einem der vorhergehenden Ansprüche, dadurch gekennzeichnet, daß die beiden mit Wällen versehenen Halbleiterscheiben (1, 2) bei so hoher Temperatur und unter derartigem mechanischem Druck zusammengesetzt werden, daß die Berührungsstellen der strukturierten Oberflächenseiten beider Halbleiterscheiben (1, 2) als Folge plastischer Verformungen des Halbleitergitters in einkristalline Engewiderstände (4) umgewandelt werden.

10. Verfahren zur Herstellung eines Feldeffekttransistors nach Anspruch 5, dadurch gekennzeichnet, daß die strukturierten Oberflächenseiten der beiden Halbleiterscheiben so zusammengesetzt werden, daß die Metallfolie oder die metallisierte Isolatorfolie an den Berührungsstellen durchstoßen und derart beiseite gedrückt wird, daß sich an den Seitenflanken der Wälle (3) Wülste (19) formen, die die Schottky-Kontakte (5) bilden.

## Claims

1. Field-effect transistor with a recessed gate, characterized in that two semiconductor disks (1 and 2) of the same conductivity type are provided, in that a structure comprised of walls (3) extending parallel to one another is provided on one side of each disk, in that the two disks (1, 2) are combined at their structured sides under mechanical pressure such that the walls (3) of both disks (1, 2) cross and contact one another so as to produce a surface distribution of constriction resistors (4) electrically connected in parallel between the two semiconductor disks (1, 2), and in that a gate electrode (5) is provided for each constriction resistor (4).

2. Field-effect transistor as defined in claim 1, characterized in that semiconductor material which forms a p/n transistion with the constriction resistors (4) is provided as gate electrode (5).

3. Field-effect transistor as defined in one of the preceding claims, characterized in that an MOS contact is provided as gate electrode (5).

4. Field-effect transistor as defined in one of the preceding claims, characterized in that a Schottky contact is provided as gate electrode (5).

5. Field-effect transistor as defined in claim 4, characterized in that a metal foil (17) or a metallized insulator foil is disposed between the structured surface side of both disks (1, 2) to produce the Schottky contacts (5).

6. Field-effect transistor as defined in one of the preceding claims, characterized in that single-crystalline or polycrystalline element-semiconductors or compound semiconductors are provided as semiconductors.

7. Field-effect transistor as defined in one of the preceding claims, characterized by its use as a switch.

8. Field-effect transistor as defined in one of the preceding claims, characterized by its use as a power amplifier.

9. Process for manufacturing a field-effect transistor as defined in one of the preceding claims, characterized in that the two semiconductor disks (1, 2) comprising walls are combined at such a high temperature and under such mechanical pressure that the points of contact on the structured surface sides of the two semiconductor disks (1, 2) are converted as a result of plastic deformations in the semiconductor grid into single-crystalline constriction resistors (4).

10. Process for manufacturing a field-effect transistor as defined in claim 5, characterized in that the structured surface sides of the two semiconductor disks are combined such that the metal foil or the metallized insulator foil is pierced at the points of contact and pushed aside so that beads (19) consistuting the Schottky contacts (5) are formed at the side flanks of the walls (3).

## Revendications

1. Transistor à effet de champ et à grille enfoncée, caractérisé en ce que deux plaquettes semiconductrices (1 et 2) à même type de conduction sont prévues; une face de chaque plaquette présente une structure de protubérances parallèles (3); les deux plaquettes (1, 2) sont assemblées sous pression, par leurs faces structurées, de façon que les protubérances (3) des deux plaquettes (1, 2) se croisent et viennent en contact, créant ainsi une distribution en surface de résistances de constriction (4) couplées électriquement en parallèle entre les deux plaquettes semiconductrices (1, 2); et une électrode de grille est prévue pour chaque résistance de constriction (4).

2. Transistor à effet de champ selon revendication 1, caractérisé en ce que l'électrode de grille (5) utilisée est un matériau semiconducteur, qui forme une jonction p/n avec les résistances de constriction (4).

3. Transistor à effet de champ selon une des revendications 1 et 2, caractérisé par l'utilisation d'un contact MOS comme électrode de grille (5).

4. Transistor à effet de champ selon une quelconque des revendications 1 à 3, caractérisé par l'utilisation d'un contact Schottky comme électrode de grille (5).

5. Transistor à effet de champ selon revendication 4, caractérisé par un film métallique (17) ou un film isolant métallisé, disposé entre les faces structurées des deux plaquettes (1, 2) pour la production des contacts Schottky (5).

6. Transistor à effet de champ selon une quelconque des revendications 1 à 5, caractérisé en ce que des semiconducteurs élémentaires, monocristallins ou polycristallins, ou des composés intermétalliques sont utilisés comme matériau semiconducteur.

7. Transistor à effet de champ selon une quelconque des revendications 1 à 6, caractérisé par son utilisation comme interrupteur.

8. Transistor à effet de champ selon une quelconque des revendications 1 à 7, caractérisé par son utilisation comme amplidicateur de puissance.

9. Procédé de fabrication d'un transistor à effet de champ selon une quelconque des revendications 1 à 8, caractérisé en ce que les deux plaquettes semiconductrices (1, 2) munies de protubérances sont assemblées à une température si élevée et sous une pression mécanique telle que les points de contact des faces structurées des deux plaquettes (1, 2) sont convertis en résistances de constriction monocristalline 4 par suite des déformations plastiques du réseau semiconductuer.

10. Procédé de fabrication d'un transistor à effet de champ selon revendication 5, caractérisé en ce que les faces structurées des deux plaquettes semiconductrices sont assemblées de façon que le film métallique ou le film isolant métallisé soit percé aux points de contact et repoussé de part et d'autre, afin de former sur les flancs latéraux des protubérances (3) des bourrelets (19) constituant les contacts Schottky (5).

Fig.1a

Fig.1b

Fig. 2

Fig. 3a

Fig. 3b